# EUROPEAN PATENT SPECIFICATION

(11) **EP 4 122 045 B1**
(45) Date of publication and mention of the grant of the patent: **11.11.2026**
(21) Application number: 21718298.9
(22) Date of filing: 17.03.2021
(51) Int. Cl.: H01P 5/02, H05K 1/14, H05K 3/36

(54) **RADIO-FREQUENCY (RF)-INTERFACE AND MODULAR PLATE**
HOCHFREQUENZ-(RF)-SCHNITTSTELLE UND MODULARE PLATTE
INTERFACE RADIOFRÉQUENCE (RF) ET PLAQUE MODULAIRE

(30) Priority: 18.03.2020 US 202016822399
(43) Date of publication of application: 25.01.2023
(73) Proprietor: Raytheon Company, Waltham, MA 02451-1449 (US)
(72) Inventor: BENEDICT, James, dover, Massachusetts 01863 (US); KLEK, Erika, dover, Massachusetts 01863 (US); HAVEN, John P., Tewksbury, Massachusetts 01876 (US); SOULIOTIS, Michael, Tewksbury, Massachusetts 01876 (US); SIKINA, Thomas V., Boston Post Road Marlboro, Massachusetts 01720 (US); SOUTHWORTH, Andrew R., Tewksbury, Massachusetts 01876 (US); WILDER, Kevin, Derry, New Hampshire 03038 (US)
(74) Representative: Crowell & Moring U.K. LLP
(86) International application number: PCT/US2021/022742
(87) International publication number: WO 2021/188657

(56) References cited:
- JP-A- 2006 245 863
- JP-A- H05 283 914
- US-A- 4 657 322
- US-A- 5 469 130
- US-A- 5 631 446
- US-A- 5 808 529
- US-A1- 2009 279 274

## Description

### CROSS REFERENCE TO RELATED APPLICATIONS

This application claims the benefit of U.S. Application No. 16/822399, filed on March 18, 2020.

### BACKGROUND

The present disclosure relates to an apparatus and methods for providing board-to-board radio-frequency (RF) connections and, in particular, to an RF-interface and modular plate in which a structural plate and a thermal plate are used to make both RF and direct current (DC) connections to a printed circuit board (PCB). This enables a low profile RF Panel architecture by integrating the backplane, RF distribution, thermal and structural design into one assembly.

Beamformers and power dividers historically use a large amount of space on an array backplane, are difficult to integrate with thermal solutions and use a large amount RF connectors which drives up costs.

RF connectors are currently used to make connections between printed circuit boards (PCBs) and are traditionally precision machined from corrosion resistant materials. Because of this, RF connectors tend to be one of the largest cost drivers on RF PCBs. In addition, cable interfaces are sometimes required, which drive further costs, and RF connectors are typically installed by a solder reflow process, or manually, which leads to unnecessary processing time and assembly costs. Also, RF connectors are usually attached on the top surface or on the side of a PCB and are not low profile (they are usually taller than 3 mm), which prevents those PCBs from being stacked in a spatially efficient manner.

Currently, radar modular assemblies (RMA's) are connected together with phase matched cables to split or combine signals. This approach is robust, but uses expensive phase matched cables, realizing a design of a final system is complicated and a large amount of touch labor is often required to integrate systems together. Recently, SNAP-RF has proven that board-to-board interconnections are possible using just two different dielectric boards but, while SNAP-RF can provide for thinner than conventional beamforming systems, for example, SNAP-RF still provides for relatively thick assemblies.

For further background, US 5,631,446A describes an RF flexible printed wiring board transmission line for connecting strip transmission line microwave assemblies without the use of coaxial connectors and coaxial cables. The flexible transmission line includes a thin flexible dielectric ribbon, having on one side a ground plane layer and on the other side a microstrip conductor strip.

US 5,469,130A describes a high frequency parallel strip line cable including a pair of thin-film-shaped earth conductors formed on both surfaces of a dielectric body so as to oppose to each other, where a thin-film-shaped center conductor is formed in the dielectric body so as to be located between the pair of earth conductors, and the connector part is formed in one end of the high frequency parallel strip line cable so as to expose one end of the center conductor. Further, a connector is provided for connecting with the connector part of the high frequency parallel strip line cable.

US 5,808,529A describes a ground plane interconnection that is provided on first and second substrates, the first and second substrates having respective first and second ground layers disposed on a first surface of each of the first and second substrates. A ground conductor strip is disposed on a second surface of the second substrate, wherein the ground conductor strip includes a plurality of electrically conductive members which pass through the second substrate to electrically couple the ground conductor strip and the second ground layer. The first substrate is positioned with respect to the second substrate such that when the first substrate is placed proximate the second substrate, the ground conductor strip electrically couples the first and second ground layers to form a continuous ground plane.

US 2009/279274A describes circuit boards tha are individually screened by conductive screening layers and the individual screening layers are coupled together by layered interconnects which connect corresponding screening layers of the individual circuit boards together, instead of by vias.

JP H05283914 A describes strip line to be used, such as in the microwave circuit and microwave antenna feed line.

JP 2006 245843 A describes a strip line, and more particularly to a flexible strip line useful for connecting a high-frequency circuit board or between a high-frequency circuit board and an antenna.

### SUMMARY

A RAMP-radio frequency (RAMP-RF) assembly is provided in accordance with independent claim 1. There is also provided a method of assembling a RAMP RF assembly according to independent claim 7. Further embodiments of the invention are described in dependent claims.

### BRIEF DESCRIPTION OF THE SEVERAL VIEWS OF THE DRAWINGS

For a more complete understanding of this disclosure, reference is now made to the following brief description, taken in connection with the accompanying drawings and detailed description, wherein like reference numerals represent like parts:
FIG. 1 is a perspective view of a component in accordance with embodiments;
FIG. 2 is a side view of a RAMP-RF assembly of the encircled portion of the component of FIG. 1 in accordance with embodiments;
FIG. 3 is a perspective view of a microstrip-to-stripline transition element of the RAMP-RF assembly of FIG. 2 in accordance with embodiments;
FIG. 4 is a side view of a RAMP-RF assembly of the encircled portion of the component of FIG. 1 in accordance with an example not covered by the claims;
FIG. 5 is a perspective view of a microstrip-to-stripline transition element of the RAMP-RF assembly of FIG. 4 in accordance with said example; and
FIG. 6 is a flow diagram illustrating a method of assembling a RAMP-RF assembly in accordance with embodiments.

### DETAILED DESCRIPTION

As will be described below, a RAMP-RF assembly is provided and uses PCB substrates to transmit RF signals throughout an assembly and a bent PCB or printed wiring board (PWB) to form a microstrip-to-stripline transition that interfaces between two different boards without the use of an external connector. The RAMP-RF assembly thus integrates structural, thermal, microwave, DC and logic connections all in one plate.

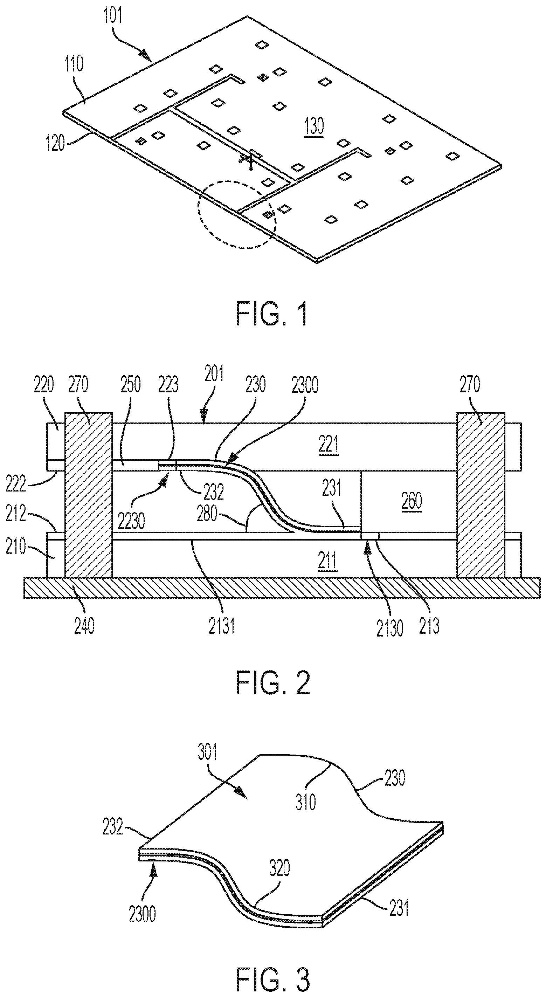

With reference to FIG. 1, a component 101 is provided for use in various applications, such as a radar modular assembly (RMA) or another similar type of device. The component 101 includes multiple layers 110 and 120 and has an uppermost major surface 130 in which various electrical and electromechanical devices are disposed. These electrical and electromechanical device include, but not limited to, integrated circuits (ICs), antenna elements and faraday wall elements.

With reference to FIGS. 2 and 3, a side view of the encircled portion of the component 101 of FIG. 1 is illustrated not to scale and includes a RAMP-radio frequency (RAMP-RF) assembly 201. As shown in FIGS. 2 and 3, the RAMP-RF assembly 201 includes an RF panel 210, a plate 220, a microstrip-to-stripline transition element 230 and a PCB 240 on which the RF panel 210 is disposed. The RF panel 210 exhibits frequency independence and is operable at frequencies of up to 8-12 GHz (or higher or lower). The RF panel 210 includes a body 211 having an upper surface 212 and a microstrip interface 213 at the upper surface 212. The plate 220 can be provided as at least one of a structural plate and a thermal plate and includes a body 221 having a lower surface 222 and a stripline interface 223 at the lower surface 222. The microstrip-to-stripline transition element 230 has a first longitudinal end 231 and a second longitudinal end 232 opposite the first longitudinal end 231 and is operably connectable at the first longitudinal end 231 to the microstrip interface 213 at the upper surface 212 of the RF panel 210 and at the second longitudinal end 232 to the stripline interface 223 at the lower surface 222 of the plate 220.

In accordance with embodiments, the microstrip interface 213 at the upper surface 212 of the RF panel 210 includes a ground-signal (GS) configuration 2130 and the stripline interface 223 at the lower surface 222 of the plate 220 includes a ground-signal-ground (GSG) configuration 2230. The GS configuration 2130 is characterized in that a ground conductor and a signal conductor are provided on opposite sides of dielectric material, which insulates the signal conductor from the ground conductor. In accordance with further embodiments, the ground conductor of the GS configuration 2130 can extend along the upper surface 212 of the RF panel 210 as a trace 2131. The GSG configuration 2230 is characterized in that dielectric material is provided on opposite sides of a signal conductor and that the signal conductor and the dielectric material are interposed between ground conductors such that the dielectric material insulates the signal conductor from the ground conductors. The microstrip-to-stripline transition element 230 can include a GSG configuration 2300 similar to the GSG configuration 2230 of the stripline interface 223. As such, the upper ground conductor of the GSG configuration 2300 of the microstrip-to-stripline transition element 230 terminates at the microstrip interface 213.

With continued reference to FIG. 2, the RAMP-RF assembly 201 can further include at least one of a chip element 250 at the microstrip interface 213, one or more additional chip elements 260 interposed between the RF panel 210 and the plate 220, fastening elements 270 and solder 280. The chip element 250 can be disposed in signal communication with the second longitudinal end 232 of the microstrip-to-stripline transition element 230 and the one or more additional chip elements 260 can be disposed in signal communication with the first longitudinal end 231 of the microstrip-to-stripline transition element 230 (i.e., with the terminus of the upper ground conductor of the GSG configuration 2300 of the microstrip-to-stripline transition element 230). The fastening elements 270 can be coupled to the RF panel 210 and the plate 220 to apply a compressive force between the RF panel 210 and the plate 220 and onto the microstrip-to-stripline transition element 230 in order to reduce a total height of the RAMP-RF assembly 201 (e.g., a distance between the upper surface 212 of the RF panel 210 and the lower surface 222 of the plate 220 may be about ~1.1mm and a total height of the microstrip-to-stripline transition element 230 may be about ~2mm or about ~1.5-~2mm) and to increase a reliability between the connections of the microstrip-to-stripline transition element 230 to the microstrip interface 213 and to the stripline interface 223. The solder 280 can be applied to multiple locations of the RAMP-RF assembly 201 including, but not limited to, at least a mechanical interface of the RF panel 210 and the microstrip-to-stripline transition element 230, in order to provide and increase support for the microstrip-to-stripline transition element 230.

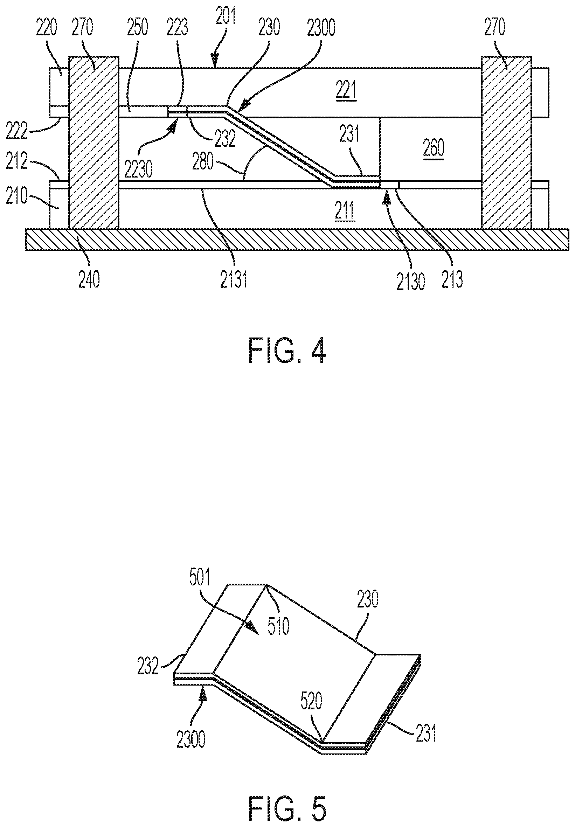

With continued reference to FIGS. 2 and 3 and with additional reference to FIGS. 4 and 5, which illustrate the RAMP-RF assembly 201 in accordance with examples not covered by the claims that are generally similar to those of FIGS. 2 and 3, the microstrip-to-stripline transition element 230 can be at least partially curvilinear 301 as shown in FIGS. 2 and 3. In an example, at least partially angular 501 as shown in FIGS. 4 and 5. That is, where the curvilinear embodiments of the microstrip-to-stripline transition element 230 of FIGS. 2 and 3 can have first and second curved or rounded inflexion points 310 and 320. The angular examples of the microstrip-to-stripline transition element 230 of FIGS. 4 and 5 can have first and second angular inflexion points 510 and 520.

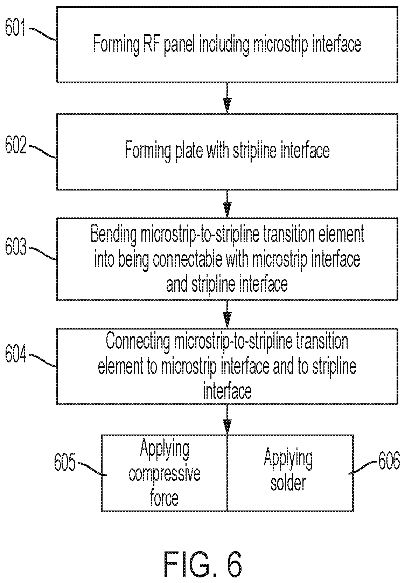

With reference to FIG. 6, a method of assembling the RAMP-RF assembly 201 as described above is provided. As shown in FIG. 6, the method includes forming the RF panel 210 having the upper surface 212 to include the microstrip interface 213 at the upper surface 212 (601) and forming the plate 220 having the lower surface 222 to include the stripline interface 223 at the lower surface 222 (601). The method further includes bending the microstrip-to-stripline transition element 230 having the first and second longitudinal ends 231 and 232 into a condition of being operably connectable at the first longitudinal end 231 to the microstrip interface 213 at the upper surface 212 of the RF panel 210 and at the second longitudinal end 232 to the stripline interface 223 at the lower surface 222 of the plate 220 (603). In addition, the method can include connecting the first and second longitudinal ends 231 and 232 of the microstrip-to-stripline transition element 230 to the microstrip interface 213 and to the stripline interface 223, respectively (604).

In accordance with embodiments, the bending of operation 603 includes bending the microstrip-to-stripline transition element 230 to be at least partially curvilinear (see FIGS. 2 and 3). In an example not covered by the claims, bending the microstrip-to-stripline transition element 230 is at least partially angular (see FIGS. 4 and 5). In accordance with further embodiments, the method can include at least one of applying a compressive force through the RF panel 210 and the plate 220 to the microstrip-to-stripline transition element 230 by way of the fastening elements 270 (605) and applying the solder 280 to at least a mechanical interface of the RF panel 210 and the microstrip-to-stripline transition element 230 (606).

Technical effects and benefits of the present invention are the provision of a RAMP-RF assembly that uses structural and thermal plates to make both RF and DC connections to a PCB board. The approach eliminates phase matched cables, allows the entire array to reach a lower profile, integrates thermal, structural and distribution layers together into one assembly, integrates Faraday Walls into a plate to control mode propagation, increases the area available for thermal distribution and provides for a simple stripline-to-microstrip transition with pressure contact made with fasteners.

The description of the present invention has been presented for purposes of illustration and description, but is not intended to be exhaustive or limited to the invention in the form disclosed. Many modifications and variations will be apparent to those of ordinary skill in the art without departing from the scope of the invention. The embodiments were chosen and described in order to best explain the principles of the invention and the practical application, and to enable others of ordinary skill in the art to understand the invention for various embodiments with various modifications as are suited to the particular use contemplated.

While the preferred embodiments to the invention have been described, it will be understood that those skilled in the art, both now and in the future, may make various improvements and enhancements which fall within the scope of the claims which follow.

These claims should be construed to maintain the proper protection for the invention first described.

## Claims

1. A RAMP-radio frequency, RAMP-RF, assembly (201), comprising:
an RF panel (210) having an upper surface (212) and comprising a microstrip interface (213) at the upper surface (212), the microstrip interface (213) comprising a ground-signal configuration;
a plate (220) having a lower surface (222) comprising a stripline interface (223) at the lower surface (222), the stripline interface (223) comprising a ground-signal-ground configuration;
a microstrip-to-stripline transition element (230) that comprises a ground-signal-ground configuration, is at least partially curvilinear,
wherein the microstrip-to-stripline transition element (230) has first and second ends (231, 232) and the microstrip-to-stripline transition element (230) is operably connectable at the first end (231) thereof to the microstrip interface (213) at the upper surface (212) of the RF panel (210) and at the second end (232) thereof to the stripline interface (223) at the lower surface (222) of the plate (220); and
one or more chip elements (260) interposed between the upper surface (212) of the RF panel (210) and the lower surface (222) of the plate (220),
wherein the one or more chip elements (260) are disposed in signal communication with a terminus of an upper ground conductor of the ground-signal-ground configuration of the microstrip-to-stripline transition element (230) at the first end (231) of the microstrip-to-stripline transition element (230).

2. The RAMP-RF assembly (201) according to claim 1, wherein the upper ground conductor of the ground-signal-ground configuration of the microstrip-to-stripline transition element (230) terminates at the microstrip interface.

3. The RAMP-RF assembly (201) according to claim 1 or claim 2, further comprising a printed circuit board, PCB, (240) on which the RF panel (210) is disposed.

4. The RAMP-RF assembly (201) according to claim 1 or claim 2, wherein the plate (220) comprises at least one of a structural plate and a thermal plate.

5. The RAMP-RF assembly (201) according to claim 1 or claim 2, further comprising at least one of an additional chip element (250) at the microstrip interface (213).

6. The RAMP-RF assembly (201) according to claim 1 or claim 2, further comprising at least one of:
fastening elements (270) coupled to the RF panel (210) and the plate (220) to apply a compressive force to the microstrip-to-stripline transition element (230); and
solder (280) applied to at least a mechanical interface of the RF panel (210) and the microstrip-to-stripline transition element (230).

7. A method of assembling a RAMP-radio frequency, RAMP-RF, assembly (201), the method comprising:
forming an RF panel (210) having an upper surface (212) to comprise a microstrip interface (213) at the upper surface (212), the microstrip interface (213) comprising a ground-signal configuration;
forming a plate (220) having a lower surface (222) to comprise a stripline interface (223) at the lower surface (222), the stripline interface (223) comprising a ground-signal-ground configuration;
bending a microstrip-to-stripline transition element (230) comprising a ground-signal-ground configuration and having first and second ends (231, 232) into operable connection at the first end (231) thereof to the microstrip interface (213) at the upper surface (212) of the RF panel (210) and at the second end (232) thereof to the stripline interface (223) at the lower surface (222) of the plate (220), wherein the bending comprises bending the microstrip-to-stripline transition element (230) to be at least partially curvilinear;
interposing one or more chip elements (260) between the upper surface (212) of the RF panel (210) and the lower surface (222) of the plate (220); and
disposing the one or more chip elements (260) in signal communication with a terminus of an upper ground conductor of the ground-signal-ground configuration of the microstrip-to-stripline transition element (230) at the first end (231) of the microstrip-to-stripline transition element (230).

8. The method according to claim 7, further comprising at least one of:
applying a compressive force through the RF panel (210) and the plate (220) to the microstrip-to-stripline transition element (230); and
applying solder (280) to at least a mechanical interface of the RF panel (210) and the microstrip-to-stripline transition element (230).

## Patentansprüche

1. RAMP-Hochfrequenz-, RAMP-RF-, Anordnung (201), umfassend:
ein RF-Panel (210), das eine obere Oberfläche (212) aufweist und eine Mikrostreifen-Schnittstelle (213) an der oberen Oberfläche (212) umfasst, wobei die Mikrostreifen-Schnittstelle (213) eine Masse-Signal-Konfiguration umfasst; eine Platte (220), die eine untere Oberfläche (222) aufweist, die eine Streifenleitungs-Schnittstelle (223) an der unteren Oberfläche (222) umfasst, wobei die Streifenleitungs-Schnittstelle (223) eine Masse-Signal-Masse-Konfiguration umfasst;
ein Mikrostreifen-zu-Streifenleitungs-Übergangselement (230), das eine Masse-Signal-Masse-Konfiguration umfasst, zumindest teilweise krummlinig ist,
wobei das Mikrostreifen-zu-Streifenleitungs-Übergangselement (230) ein erstes und ein zweites Ende (231, 232) aufweist und das Mikrostreifen-zu-Streifenleitungs-Übergangselement (230) an dem ersten Ende (231) davon mit der Mikrostreifen-Schnittstelle (213) an der oberen Oberfläche (212) des RF-Panels (210) und an dem zweiten Ende (232) davon mit der Streifenleitungs-Schnittstelle (223) an der unteren Oberfläche (222) der Platte (220) operativ verbindbar ist; und
ein oder mehrere Chipelemente (260), die zwischen der oberen Oberfläche (212) des RF-Panels (210) und der unteren Oberfläche (222) der Platte (220) eingefügt sind,
wobei das eine oder die mehreren Chipelemente (260) in Signalkommunikation mit einem Endpunkt eines oberen Masseleiters der Masse-Signal-Masse-Konfiguration des Mikrostreifen-zu-Streifenleitungs-Übergangselements (230) an dem ersten Ende (231) des Mikrostreifen-zu-Streifenleitungs-Übergangselements (230) eingerichtet sind.

2. RAMP-RF-Anordnung (201) nach Anspruch 1 , wobei der obere Masseleiter der Masse-Signal-Masse-Konfiguration des Mikrostreifen-zu-Streifenleitungs-Übergangselements (230) an der Mikrostreifen-Schnittstelle endet.

3. RAMP-RF-Anordnung (201) nach Anspruch 1 oder Anspruch 2, ferner umfassend eine Leiterplatte, PCB, (240), auf der das RF-Panel (210) eingerichtet ist.

4. RAMP-RF-Anordnung (201) nach Anspruch 1 oder Anspruch 2, wobei die Platte (220) mindestens eine von einer Strukturplatte und einer thermischen Platte umfasst.

5. RAMP-RF-Anordnung (201) nach Anspruch 1 oder Anspruch 2, ferner umfassend mindestens eines von einem zusätzlichen Chipelement (250) an der Mikrostreifen-Schnittstelle (213).

6. RAMP-RF-Anordnung (201) nach Anspruch 1 oder Anspruch 2, ferner umfassend mindestens eines von Folgendem:
Befestigungselementen (270), die mit dem RF-Panel (210) und der Platte (220) gekoppelt sind, um eine Druckkraft auf das Mikrostreifen-zu-Streifenleitungs-Übergangselement (230) auszuüben; und
Lot (280), das auf mindestens eine mechanische Schnittstelle des RF-Panels (210) und des Mikrostreifen-zu-Streifenleitungs-Übergangselements (230) aufgebracht ist.

7. Verfahren zum Montieren einer RAMP-Hochfrequenz-, RAMP-RF-, Anordnung (201), wobei das Verfahren umfasst:
Ausbilden eines RF-Panels (210), das eine obere Oberfläche (212) aufweist, um eine Mikrostreifen-Schnittstelle (213) an der oberen Oberfläche (212) zu umfassen, wobei die Mikrostreifen-Schnittstelle (213) eine Masse-Signal-Konfiguration umfasst;
Ausbilden einer Platte (220), die eine untere Oberfläche (222) aufweist, um eine Streifenleitungs-Schnittstelle (223) an der unteren Oberfläche (222) zu umfassen, wobei die Streifenleitungs-Schnittstelle (223) eine Masse-Signal-Masse-Konfiguration umfasst;
Biegen eines Mikrostreifen-zu-Streifenleitungs-Übergangselements (230), das eine Masse-Signal-Masse-Konfiguration umfasst und ein erstes und ein zweites Ende (231, 232) aufweist, in operative Verbindung an dem ersten Ende (231) davon mit der Mikrostreifen-Schnittstelle (213) an der oberen Oberfläche (212) des RF-Panels (210) und an dem zweiten Ende (232) davon mit der Streifenleitungs-Schnittstelle (223) an der unteren Oberfläche (222) der Platte (220), wobei das Biegen Biegen des Mikrostreifen-zu-Streifenleitungs-Übergangselements (230) derart, dass es zumindest teilweise krummlinig ist, umfasst;
Einfügen eines oder mehrerer Chipelemente (260) zwischen die obere Oberfläche (212) des RF-Panels (210) und die untere Oberfläche (222) der Platte (220); und
Einrichten des einen oder der mehreren Chipelemente (260) in Signalkommunikation mit einem Endpunkt eines oberen Masseleiters der Masse-Signal-Masse-Konfiguration des Mikrostreifen-zu-Streifenleitungs-Übergangselements (230) an dem ersten Ende (231) des Mikrostreifen-zu-Streifenleitungs-Übergangselements (230).

8. Verfahren nach Anspruch 7, ferner umfassend mindestens eines von Folgendem:
Ausüben einer Druckkraft durch das RF-Panel (210) und die Platte (220) auf das Mikrostreifen-zu-Streifenleitungs-Übergangselement (230); und
Aufbringen von Lot (280) auf mindestens eine mechanische Schnittstelle des RF-Panels (210) und des Mikrostreifen-zu-Streifenleitungs-Übergangselements (230).

## Revendications

1. Ensemble RAMP-radiofréquence, RAMP-RF, (201), comprenant :
un panneau RF (210) présentant une surface supérieure (212) et comprenant une interface microbande (213) au niveau de la surface supérieure (212), l'interface microbande (213) comprenant une configuration masse-signal ;
une plaque (220) présentant une surface inférieure (222) comprenant une interface triplaque (223) au niveau de la surface inférieure (222), l'interface triplaque (223) comprenant une configuration masse-signal-masse ;
un élément de transition microbande-triplaque (230) qui comprend une configuration masse-signal-masse, est au moins partiellement curviligne,
dans lequel l'élément de transition microbande-triplaque (230) présente des première et seconde extrémités (231, 232) et l'élément de transition microbande-triplaque (230) peut être raccordé de manière fonctionnelle, au niveau de la première extrémité (231) de celui-ci, à l'interface microbande (213) au niveau de la surface supérieure (212) du panneau RF (210) et, au niveau de la seconde extrémité (232) de celui-ci, à l'interface triplaque (223) au niveau de la surface inférieure (222) de la plaque (220) ; et
un ou plusieurs éléments de puce (260) interposés entre la surface supérieure (212) du panneau RF (210) et la surface inférieure (222) de la plaque (220),
dans lequel les un ou plusieurs éléments de puce (260) sont disposés en communication de signaux avec une terminaison d'un conducteur de masse supérieur de la configuration masse-signal-masse de l'élément de transition microbande-triplaque (230) au niveau de la première extrémité (231) de l'élément de transition microbande-triplaque (230).

2. Ensemble RAMP-RF (201) selon la revendication 1, dans lequel le conducteur de masse supérieur de la configuration masse-signal-masse de l'élément de transition microbande-triplaque (230) se termine au niveau de l'interface microbande.

3. Ensemble RAMP-RF (201) selon la revendication 1 ou la revendication 2, comprenant en outre une carte de circuit imprimé, PCB, (240) sur laquelle le panneau RF (210) est disposé.

4. Ensemble RAMP-RF (201) selon la revendication 1 ou la revendication 2, dans lequel la plaque (220) comprend au moins l'une d'une plaque structurelle et d'une plaque thermique.

5. Ensemble RAMP-RF (201) selon la revendication 1 ou la revendication 2, comprenant en outre au moins l'un d'un élément de puce supplémentaire (250) au niveau de l'interface microbande (213).

6. Ensemble RAMP-RF (201) selon la revendication 1 ou la revendication 2, comprenant en outre au moins l'un des éléments suivants :
des éléments de fixation (270) accouplés au panneau RF (210) et à la plaque (220) pour appliquer une force de compression à l'élément de transition microbande-triplaque (230) ; et
de la brasure (280) appliquée sur au moins l'une d'une interface mécanique du panneau RF (210) et de l'élément de transition microbande-triplaque (230).

7. Procédé d'assemblage d'un ensemble RAMP-radiofréquence, RAMP-RF, (201), le procédé comprenant :
la formation d'un panneau RF (210) présentant une surface supérieure (212) de sorte qu'il comprenne une interface microbande (213) au niveau de la surface supérieure (212), l'interface microbande (213) comprenant une configuration masse-signal ;
la formation d'une plaque (220) présentant une surface inférieure (222) de sorte qu'elle comprenne une interface triplaque (223) au niveau de la surface inférieure (222), l'interface triplaque (223) comprenant une configuration masse-signal-masse ;
le cintrage d'un élément de transition microbande-triplaque (230) comprenant une configuration masse-signal-masse et présentant des première et seconde extrémités (231, 232) en raccordement fonctionnel, au niveau de la première extrémité (231) de celui-ci, à l'interface microbande (213) au niveau de la surface supérieure (212) du panneau RF (210) et, au niveau de la seconde extrémité (232) de celui-ci, à l'interface triplaque (223) au niveau de la surface inférieure (222) de la plaque (220), dans lequel le cintrage comprend le cintrage de l'élément de transition microbande-triplaque (230) de sorte qu'il soit au moins partiellement curviligne ;
l'interposition d'un ou plusieurs éléments de puce (260) entre la surface supérieure (212) du panneau RF (210) et la surface inférieure (222) de la plaque (220) ; et
la disposition des un ou plusieurs éléments de puce (260) en communication de signaux avec une terminaison d'un conducteur de masse supérieur de la configuration masse-signal-masse de l'élément de transition microbande-triplaque (230) au niveau de la première extrémité (231) de l'élément de transition microbande-triplaque (230).

8. Procédé selon la revendication 7, comprenant en outre au moins l'une des étapes suivantes :
l'application d'une force de compression, à travers le panneau RF (210) et la plaque (220), à l'élément de transition microbande-triplaque (230) ; et
l'application de brasure (280) sur au moins l'une d'une interface mécanique du panneau RF (210) et de l'élément de transition microbande-triplaque (230).
